# FASCICULE DE BREVET EUROPEEN

(11) **EP 4 117 002 B1**
(45) Date de publication et mention de la délivrance du brevet: **24.01.2024**
(21) Numéro de dépôt: 22183747.9
(22) Date de dépôt: 08.07.2022
(51) Int. Cl.: H01H 9/16, H01H 71/04

(54) **MODULE AUXILIAIRE POUR UN DISPOSITIF DE COMMUTATION ÉLECTRIQUE, DISPOSITIF DE COMMUTATION ET SYSTÈME DE SURVEILLANCE ASSOCIÉS**
HILFSMODUL FÜR EINE ELEKTRISCHE SCHALTVORRICHTUNG, ENTSPRECHENDE SCHALTVORRICHTUNG UND ENTSPRECHENDES ÜBERWACHUNGSSYSTEM
AUXILIARY MODULE FOR AN ELECTRICAL SWITCHING DEVICE, ASSOCIATED SWITCHING DEVICE AND MONITORING SYSTEM

(30) Priorité: 09.07.2021 FR 2107462
(43) Date de publication de la demande: 11.01.2023
(73) Titulaire: Schneider Electric Industries SAS, 92500 Rueil-Malmaison (FR)
(72) Inventeur: BURDY, Laurent, 38570 THEYS (FR); DORLIN, Flavien, 38100 GRENOBLE (FR)
(74) Mandataire: Lavoix

(56) Documents cités:
- DE-A1-102018 221 033
- US-A1- 2013 329 331
- US-A1- 2016 033 553
- US-A1- 2019 140 429
- US-A1- 2019 140 439

## Description

La présente invention concerne un module auxiliaire pour un dispositif de commutation électrique. La présente invention concerne également un dispositif de commutation électrique comportant un tel module auxiliaire. Le document DE102018221033 décrit un dispositif selon le préambule de la revendication 1.

Des dispositifs de commutation électrique sont utilisés dans un très grand nombre d'installations pour commander des courants électriques, notamment pour interrompre les courants électriques soit sur une commande d'un opérateur soit automatiquement en cas de détection d'un défaut électrique, par exemple une surtension, un surcourant, un arc électrique ou encore un court-circuit, entre autres.

Ces dispositifs jouent donc un rôle important dans la sécurité des installations électriques qui les contiennent, et il est important de pouvoir connaître l'état de chacun de ces dispositifs de commutation afin d'assurer le bon fonctionnement de ces installations. Par exemple, savoir qu'un dispositif de commutation a coupé le courant suite à la détection d'un défaut implique souvent de corriger ce défaut avant de remettre l'installation en fonctionnement, tandis que si ce dispositif de commutation est dans son état fermé, où il permet la circulation du courant, il n'y a pas besoin d'intervenir.

A cet effet, il est connu d'utiliser des modules auxiliaires, qui peuvent être ajoutés à certains dispositifs de commutation électrique pour détecter dans quel état se trouve le dispositif de commutation et pour transmettre cette information à un dispositif de surveillance de l'installation. Pour cela, les modules auxiliaires comportent un élément mécanique actionné par un organe correspondant du dispositif de commutation en fonction de l'état de ce dernier, la position de cet élément mécanique modifiant une propriété d'un circuit électrique du module auxiliaire, le circuit étant connecté par un ou plusieurs conducteurs au dispositif de surveillance. Ainsi, la modification des propriétés d'un courant électrique ou d'une tension électrique du ou des conducteurs renseigne le dispositif de surveillance sur l'état du dispositif de commutation.

Toutefois, la présence des conducteurs électriques reliant le module auxiliaire au dispositif de surveillance rend l'intégration des modules auxiliaires complexes, puisque l'installation dans laquelle ils sont intégrés doit permettre le passage de ces conducteurs. En outre, si des conducteurs sont endommagés, le module auxiliaire est rendu inopérant, puisque le signal qu'il génère ne peut être transmis au dispositif de surveillance.

Il existe donc un besoin pour un module auxiliaire pour un dispositif de commutation électrique, qui soit propre à indiquer un état du dispositif de commutation à un dispositif distant de ce dernier, et qui soit plus simple d'intégration et plus sécurisé que les modules auxiliaires de l'état de la technique.

A cet effet, il est proposé un module auxiliaire pour un dispositif de commutation électrique, le dispositif de commutation électrique comprenant au moins une entrée, une sortie, un premier boîtier et un module de commutation configuré pour commuter entre une première configuration dans laquelle le module de commutation permet le passage d'un courant électrique entre l'entrée et la sortie et une deuxième configuration dans laquelle le module de commutation empêche le passage du courant entre l'entrée et la sortie, le premier boîtier délimitant une chambre accueillant le module de commutation, le premier boitier délimitant en outre un emplacement de réception du module auxiliaire, l'emplacement comportant au moins un organe de signalisation configuré pour transmettre au module auxiliaire une première information relative à un état du dispositif de commutation électrique lorsque le module auxiliaire est accueilli dans l'emplacement, le module auxiliaire comprenant un contrôleur configuré pour générer un message contenant des deuxièmes informations représentatives de la première information transmise, et un module de communication radiofréquence configuré pour transmettre le message, via une liaison de données radiofréquence, à un dispositif distant du dispositif de commutation électrique. Le module auxiliaire comprend un deuxième boîtier, une première carte de circuit imprimé, une deuxième carte de circuit imprimé et un élément mobile, le deuxième boîtier délimitant une chambre accueillant la première carte et la deuxième carte, la première carte de circuit imprimé portant le contrôleur et s'étendant dans un premier plan, la deuxième carte de circuit imprimé étant connectée à la première carte de circuit imprimé et s'étendant à partir de la première carte de circuit imprimé selon une direction perpendiculaire au premier plan, la deuxième carte de circuit imprimé portant un circuit électrique connecté au contrôleur, l'élément mobile étant configuré pour être déplacé en translation par l'organe de signalisation selon une direction de translation entre une première position dans laquelle le circuit électrique est ouvert et une deuxième position dans laquelle l'élément mobile ferme le circuit électrique, l'état du dispositif de commutation étant indiqué par l'état ouvert ou fermé dudit circuit électrique.

Grâce à l'utilisation d'une liaison de données radiofréquence, il n'est plus nécessaire de prévoir des passages dédiés pour les conducteurs électriques reliant le module auxiliaire au dispositif de surveillance, et le risque de perte de communication entre le module auxiliaire et le dispositif de surveillance est réduit puisqu'il n'est alors plus sensible à l'endommagement d'un conducteur électrique. Le module auxiliaire est donc à la fois plus facile à intégrer et plus sécurisé.

Selon des modes de réalisation avantageux mais non obligatoires, le module auxiliaire présente une ou plusieurs des caractéristiques suivantes, prises isolément ou selon toutes les combinaisons techniquement possibles :
- la direction de translation est perpendiculaire à un deuxième plan d'extension de la deuxième carte de circuit imprimé, la direction de translation étant notamment une direction selon laquelle le module auxiliaire est propre à être inséré dans l'emplacement ou extrait de l'emplacement.
- la deuxième carte de circuit imprimé comporte au moins une projection insérée dans un trou traversant la première carte de circuit imprimé de manière à empêcher une translation relative des deux cartes de circuit imprimé l'une par rapport à l'autre dans le premier plan.
- la première carte de circuit imprimé porte au moins deux premières plages de connexion et la deuxième carte de circuit imprimé porte au moins deux deuxièmes plage de connexion, chaque première ou deuxième plage étant portée par une face de la carte correspondante, chaque deuxième plage étant connectée à une des premières plages de connexion pour permettre à un courant électrique de circuler entre la première plage de connexion et la deuxième plage de connexion, les deux deuxièmes plages ou deux des deuxièmes plages étant reliées audit circuit électrique, chaque première plage étant soudée à la deuxième plage correspondante par une masse de métal électriquement conducteur.
- la deuxième carte de circuit imprimé présente deux faces délimitant la deuxième carte selon une direction perpendiculaire au deuxième plan, chacune des deux faces de la deuxième carte portant au moins une des deuxièmes plages de connexion.
- chaque carte de circuit imprimé comporte, pour au moins une des premières ou deuxièmes plages de la carte considérée, un ensemble de vias traversant la carte selon une direction perpendiculaire au premier ou deuxième plan d'extension de la carte considérée, chaque via débouchant à travers la première ou deuxième plage et contenant un élément métallique traversant la carte de circuit imprimé considérée.
- le module auxiliaire comporte un organe de stockage d'énergie électrique prévu pour alimenter électriquement le contrôleur et le module de communication, l'organe de stockage s'étendant dans un troisième plan parallèle au premier plan et présentant au moins une face latérale délimitant l'organe de stockage dans le troisième plan, l'organe de stockage comportant un premier contact électrique et un deuxième contact électrique et étant configuré pour imposer une tension électrique entre le premier contact et le deuxième contact, la face latérale portant le premier contact électrique, le premier contact électrique étant connecté à un troisième contact électrique porté par la deuxième carte de circuit imprimé, le troisième contact électrique étant relié au contrôleur et au module de communication via l'une des deuxièmes plages de connexion, les deuxièmes plages de connexion étant au nombre de trois ou plus.
- la première carte de circuit imprimé comporte un quatrième contact électrique relié au contrôleur et au module de communication, le deuxième contact électrique étant en appui contre le quatrième contact électrique.
- le module de communication comporte une antenne, l'antenne comportant une zone dépourvue de revêtement métallique de la première carte de circuit imprimé et un excitateur configuré pour générer au moins une onde électromagnétique dans ladite zone.
- le module auxiliaire est prévu pour un dispositif de commutation dont le premier boîtier présente une face avant prévue pour être accessible par un opérateur lorsque le dispositif de commutation est en fonctionnement, dans lequel, lorsque le module auxiliaire est accueilli dans ledit emplacement, l'excitateur est interposé entre ladite zone et la face avant.
- le module auxiliaire est prévu pour un dispositif de commutation dont le premier boîtier présente une face avant prévue pour être accessible par un opérateur lorsque le dispositif de commutation est en fonctionnement, dans lequel la première carte de circuit imprimé présente une première extrémité et une deuxième extrémité, la première extrémité et la deuxième extrémité délimitant ensemble la première carte selon une direction perpendiculaire à la face avant, la première extrémité étant, parmi la première extrémité et la deuxième extrémité, l'extrémité la plus proche de la face avant, dans lequel l'antenne est portée par la première extrémité.

Il est également proposé un dispositif de commutation électrique comportant au moins une entrée, une sortie, un premier boîtier, un module auxiliaire tel que précédemment décrit et un module de commutation configuré pour commuter entre une première configuration dans laquelle le module de commutation permet le passage d'un courant électrique entre l'entrée et la sortie et une deuxième configuration dans laquelle le module de commutation empêche le passage du courant entre l'entrée et la sortie, le premier boîtier délimitant une chambre accueillant le module de commutation, le premier boitier délimitant en outre un emplacement de réception du module auxiliaire, l'emplacement comportant au moins un organe de signalisation configuré pour transmettre au module auxiliaire une première information relative à un état du dispositif de commutation électrique lorsque le module auxiliaire est accueilli dans l'emplacement.

Selon un mode de réalisation, le premier boîtier délimite une pluralité d'emplacements de réception configurés chacun pour accueillir un module auxiliaire tel que précédemment décrit, chaque emplacement de réception étant associé à un état respectif du dispositif de commutation électrique, différent de l'état associé à chaque autre emplacement de réception, chaque emplacement de réception comprenant un organe de signalisation respectif configuré pour transmettre à un module auxiliaire une première information relative à l'état associé lorsque le module auxiliaire est accueilli dans l'emplacement de réception.

Il est également proposé un système de surveillance d'une installation électrique, comportant au moins un dispositif de commutation tel que précédemment décrit et un dispositif de surveillance configuré pour recevoir chaque message transmis par le ou les module(s) auxiliaires.

Des caractéristiques et avantages de l'invention apparaîtront à la lecture de la description qui va suivre, donnée uniquement à titre d'exemple non limitatif, et faite en référence aux dessins annexés, sur lesquels :
[Fig 1] la figure 1 est une représentation schématique d'un exemple de système de surveillance comportant un module auxiliaire selon l'invention,
[Fig 2] la figure 2 est une vue en coupe d'un premier exemple de module auxiliaire selon l'invention, comportant entre autres deux cartes de circuit imprimé
[Fig 3] la figure 3 est une autre vue en coupe du premier exemple de module auxiliaire de la figure 2,
[Fig 4] la figure 4 est une vue en perspective des deux cartes du premier exemple de module auxiliaire,
[Fig 5] la figure 5 est une autre vue en perspective des deux cartes du premier exemple de module auxiliaire,
[Fig 6] la figure 6 est une vue en perspective des deux cartes d'un deuxième exemple de module auxiliaire, et
[Fig 7] la figure 7 est une autre vue en perspective des deux cartes du deuxième exemple de module auxiliaire.

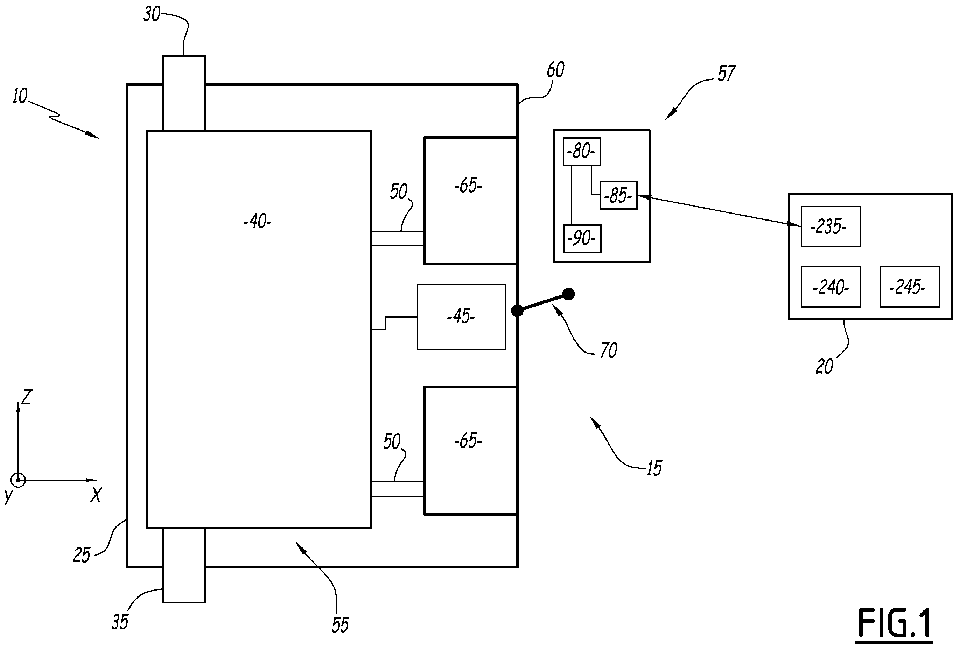

Un exemple d'un système 10 de surveillance d'une installation électrique est représenté sur la figure 1.

Le système 10 comporte un dispositif de commutation électrique 15 et un dispositif de surveillance 20.

Le dispositif de commutation 15 comporte un premier boîtier 25, une entrée 30, une sortie 35, un mécanisme de commutation 40, un module de commande 45, au moins un organe de signalisation 50 et au moins un module auxiliaire 57.

Il est à noter que le nombre d'entrées 30, de sorties 35, de mécanismes de commutation 40, de modules de commande 45 et d'organes de signalisation 50 est susceptible de varier.

Par exemple, des modes de réalisation du dispositif de commutation 15 sont susceptible de comprendre n entrées 30, n sorties 35, n mécanismes de commutation 40, et n modules de commande 45, n étant un entier supérieur strictement à 1, par exemple compris entre 2 et 4. En variante, un unique module de commande 45 est susceptible d'être présent et d'interagir avec n mécanismes de commutation 40 associés à n entrées 30 et n sorties 35.

Le premier boîtier 25 délimite une première chambre 55 accueillant au moins le mécanisme de commutation 40 et le module de commande 45. Le premier boîtier 25 est notamment configuré pour isoler électriquement de l'extérieur du premier boîtier 25 le mécanisme de commutation 40 et le module de commande 45.

Par exemple, le premier boîtier 25 est réalisé en un matériau électriquement isolant tel que le polycarbonate.

Le premier boîtier 25 est, par exemple, sensiblement parallélépipédique. Toutefois, d'autres formes de premiers boîtiers 25 sont également envisageables.

Le premier boîtier 25 est, par exemple, prévu pour être fixé à un emplacement d'une installation électrique, par exemple pour être fixé à un mur ou à une paroi d'une armoire électrique.

Le premier boîtier 25 présente une face avant 60.

En outre, le premier boîtier 25 délimite au moins un emplacement 65 de réception d'un module auxiliaire 57.

La face avant 60 est prévue pour être accessible par un opérateur lorsque le dispositif de commutation 15 est en fonctionnement, notamment lorsque le dispositif de commutation 15 est intégré dans une installation électrique. La face avant 60 comporte par exemple un ou des organes 70 accessibles par un opérateur pour interagir avec le dispositif de commutation 15.

Il est défini trois directions X, Y et Z sur la figure 1. Ces trois directions X, Y, Z sont perpendiculaires entre elles. La direction Z est, par exemple, une direction verticale lorsque le dispositif de commutation 15 est installé dans une installation. La face avant 60 est perpendiculaire à la direction X sur la figure 1.

Chaque emplacement 65 est, par exemple, ménagé sur la face avant 60.

Chaque emplacement 65 est, par exemple, formé par un renfoncement ménagé dans une face, notamment dans la face avant 60, du premier boîtier 25.

Par exemple, chaque emplacement 65 et délimité par des parois correspondantes du premier boîtier 25, et s'étend selon la direction X vers l'intérieur du premier boîtier 25 à partir de la face avant 60.

Il sera bien évident pour l'homme du métier que d'autres directions que la direction X peuvent être envisageables, et que chaque emplacement 65 est susceptible de déboucher sur une face quelconque du premier boîtier 25.

Chaque emplacement 65 comporte, notamment, un organe de signalisation 50 correspondant.

Chaque emplacement 65 est, par exemple, complémentaire du module auxiliaire 57 correspondant, de manière à empêcher un mouvement relatif entre le premier boîtier 25 et le module auxiliaire 57, lorsque le module auxiliaire est accueilli dans l'emplacement 65, excepté un mouvement d'extraction du module auxiliaire 57 hors de l'emplacement 65.

Chaque emplacement 65 est, notamment, prévu pour permettre l'insertion ou l'extraction du module auxiliaire 57 par un mouvement de translation du module auxiliaire 57 par rapport au premier boîtier 25, selon la direction d'extension de l'emplacement 65, qui est la direction X dans l'exemple représenté.

Le ou les organe(s) 70 incluent, par exemple, un organe actionnable par un opérateur pour commander le mécanisme de commutation 40 et/ou le module de commande 45, notamment un levier rotatif, ou encore un ensemble d'éléments propres à indiquer à un opérateur un état du dispositif de commutation 15, par exemple un ou des indicateurs lumineux.

Chaque entrée 30 est configurée pour être connectée à un conducteur électrique, notamment à un conducteur électrique de l'installation contenant le dispositif de commutation 15, de manière connue en soi. L'entrée 30 est, par exemple, formée par une borne de connexion permettant la fixation du conducteur électrique de manière à permettre la connexion électrique entre une partie conductrice de l'entrée 30 et le conducteur.

Chaque entrée 30 est, notamment, configurée pour recevoir un courant électrique du conducteur correspondant et pour transmettre le courant électrique reçu au mécanisme de commutation 40.

Chaque sortie 35 est configurée pour être connectée à un conducteur électrique, notamment à un conducteur électrique de l'installation contenant le dispositif de commutation 15, de manière connue en soi. La sortie 35 est, par exemple, formée par une borne de connexion permettant la fixation du conducteur électrique de manière à permettre la connexion électrique entre une partie conductrice de la sortie 35 et le conducteur.

Chaque sortie 35 est, notamment, configurée pour recevoir un courant électrique du mécanisme de commutation 40 et pour transmettre le courant électrique reçu au conducteur correspondant.

Chaque mécanisme de commutation 40 est connecté à une entrée 30 et à une sortie 35 correspondante.

En particulier, chaque mécanisme de commutation 40 est connecté à une entrée 30 et à une sortie 35 disposées sur des faces opposées du premier boîtier 25 qui délimitent ce boîtier 25 selon la direction Z. Dans ce cas, chaque mécanisme 40 s'étend sensiblement selon la direction Z.

Chaque mécanisme de commutation 40 est configuré pour, de manière connue en soi, commuter entre une première configuration et une deuxième configuration.

Dans la première configuration, le mécanisme de commutation 40 permet le passage d'un courant électrique entre l'entrée 30 et la sortie 35 correspondantes.

Dans la deuxième configuration, le mécanisme de commutation 40 isole électriquement l'entrée 30 de la sortie 35.

Le module de commande 45 est configuré pour commander la commutation d'au moins un mécanisme de commutation 40 entre la première configuration et la deuxième configuration.

Pa exemple, le module de commande 45 est configuré pour, de manière connue en soi, détecter un défaut électrique dans le courant circulant entre une entrée 30 et la sortie 35 correspondante, et pour commander la commutation du mécanisme de commutation 40 reliant l'entrée 30 et la sortie 35 depuis sa première configuration jusqu'à sa deuxième configuration. Le défaut est, par exemple, un arc électrique, une surtension, une soustension, un surcourant, ou encore un court-circuit.

Dans un tel cas, le dispositif de commutation 15 est, par exemple, un disjoncteur.

En variante ou en complément, le module de commande 45 est configuré pour faire commuter le mécanisme de commutation 40 de sa première configuration jusqu'à sa deuxième configuration, ou vice-versa, suite à la réception d'une commande transmise par un dispositif distant du dispositif de commutation 15, par exemple par le dispositif de surveillance 20. La commande est, par exemple, un signal électrique transmis par un conducteur reliant le mécanisme de commutation 40 au dispositif distant.

Des dispositifs de commutation 15 dans lesquels le module de commande 45 est commandé par un dispositif distant et n'est pas configuré pour détecter un défaut sont parfois appelés « relais » ou « interrupteurs ». Toutefois, des disjoncteurs commandables à distance par un autre dispositif sont également envisageables.

En variante ou en complément, le module de commande 45 est configuré pour faire commuter le mécanisme de commutation 40 de sa première configuration jusqu'à sa deuxième configuration, ou vice-versa, suite à un actionnement d'un organe 70 dédié (notamment d'un levier) par un opérateur.

Il est à noter que selon une autre variante, le mécanisme de commutation 40 est directement basculé de la première à la deuxième configuration, ou vice-versa, par un organe 70 sans intervention du module de commande 45.

Chaque organe de signalisation 50 est associé à un emplacement 65. Par exemple, l'organe de signalisation 50 est au moins partiellement contenu dans l'emplacement 65.

Chaque organe de signalisation 50 est configuré pour transmettre, à un module auxiliaire 57 accueilli dans l'emplacement 65 associé, une première information relative à un état du dispositif de commutation 15.

Chaque organe de signalisation 50 est, par exemple, configuré pour déplacer au moins une partie de l'organe de signalisation 50 entre deux positions en fonction de l'état du dispositif de commutation 15. Ainsi, la position de ladite partie indique dans quel état le dispositif de commutation 15 se trouve.

Les deux positions diffèrent notamment par le fait qu'au moins une partie de l'organe de signalisation 50 est déplacée, entre ses deux positions, selon la direction d'insertion X du module auxiliaire 57 dans l'emplacement 65.

Notamment, dans l'une des deux positions, au moins une partie de l'organe de signalisation 50 est accueillie dans l'emplacement 65.

En variante, l'organe de signalisation 50 comporte une ouverture ménagée dans l'une des parois qui délimitent l'emplacement 65, et la partie mobile de l'organe de signalisation 50 est disposée dans la chambre 55 en regard de l'ouverture correspondante.

Chaque organe de signalisation 50 est, notamment, configuré pour indiquer un état ou des états différent de chaque autre organe de signalisation 50, c'est-à-dire des organes de signalisation 50 associés à d'éventuels autres emplacements 65.

Par exemple, un organe de signalisation 50 est configuré pour indiquer si le mécanisme de commutation 40 est dans sa première configuration ou dans sa deuxième configuration.

Un organe de signalisation 50 est, par exemple, configuré pour indiquer si le mécanisme de commutation 40 a été commuté jusqu'à sa deuxième configuration sur commande du module de commande 45 après détection d'un défaut.

Un autre organe de signalisation 50 est configuré pour indiquer si le mécanisme de commutation 40 a été commuté jusqu'à sa deuxième configuration sur commande du module de commande 45, après réception d'une commande de commutation émise par un dispositif distant.

Un autre organe de signalisation 50 est, notamment, configuré pour indiquer si le mécanisme de commutation 40 a été commuté jusqu'à sa deuxième configuration après actionnement d'un organe 70 par un opérateur.

Chaque module auxiliaire 57 est configuré pour être accueilli dans un emplacement 65 correspondant. Par exemple, chaque module auxiliaire 57 est propre à être accueilli indifféremment dans n'importe lequel des emplacements 65 lorsque plusieurs emplacements 65 sont présents.

Il est notamment entendu par « module auxiliaire » que le module auxiliaire 57 est amovible par rapport au dispositif de commutation 15, et notamment que le module auxiliaire 57 est extractible de l'emplacement 65 dans lequel il est accueilli.

En outre, le dispositif de commutation 15 est propre à fonctionner en l'absence de tout module auxiliaire 57, auquel cas la commutation de l'organe de commutation 40 est toujours assurée, mais aucune information sur l'état du dispositif de commutation 15 n'est envoyée au dispositif de surveillance 20.

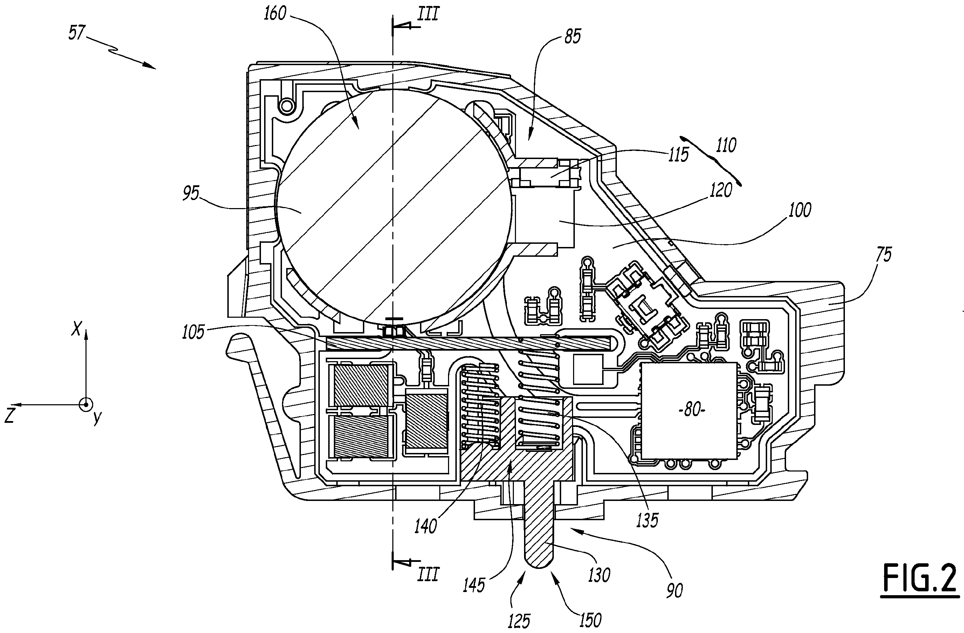

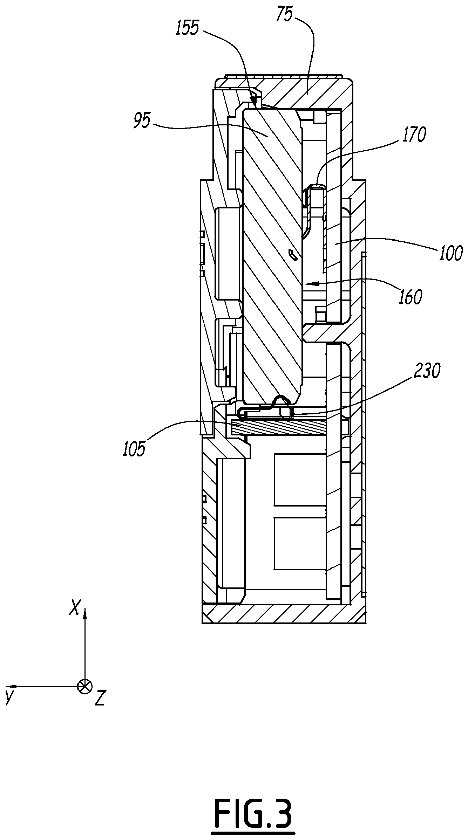

Un premier exemple de module auxiliaire 57 est représenté en coupe sur la figure 2. La coupe de la figure 2 est une coupe dans un plan formé par les directions X et Z lorsque le module auxiliaire 57 est accueilli dans l'emplacement 65 correspondant. Une coupe selon le plan B-B, parallèle au plan formé par les directions X et Y, est représentée sur la figure 3.

Chaque module auxiliaire 57 est configuré pour recevoir, de l'organe de signalisation 50 d'un emplacement dans lequel le module auxiliaire 57 est inséré, une première information relative à un état du dispositif de commutation 15.

Chaque module auxiliaire 57 comporte un deuxième boîtier 75, un contrôleur 80, un module de communication 85, des moyens 90 de réception de la première information et un organe 95 de stockage d'énergie électrique.

Dans les modes de réalisation représentés sur les figures, le module auxiliaire 57 comporte, en outre, une première carte de circuit imprimé 100 et une deuxième carte de circuit imprimé 105.

Le deuxième boîtier 75 délimite une deuxième chambre accueillant le contrôleur 80, le module de communication 85, au moins une partie des moyens 90 de réception de la première information, l'organe 95 de stockage d'énergie électrique, la première carte de circuit imprimé 100 et la deuxième carte de circuit imprimé 105.

Le deuxième boîtier 75 est réalisé en un matériau électriquement isolant, de manière à isoler électriquement de l'extérieur du deuxième boîtier 75 le contrôleur 80, le module de communication 85, au moins une partie des moyens 90 de réception de la première information, l'organe 95 de stockage d'énergie électrique, la première carte de circuit imprimé 100 et la deuxième carte de circuit imprimé 105.

Le deuxième boîtier 75 est, par exemple, réalisé en polycarbonate.

Le contrôleur 80 est configuré pour recevoir, des moyens de réception 90, la première information transmise par l'organe de signalisation 50. Le contrôleur 80 est, en outre, configuré pour générer un message, à destination du dispositif de surveillance 20, contenant des deuxièmes informations.

Les deuxièmes informations sont des informations représentatives de la première information reçue.

Par exemple, le contrôleur 80 reçoit sur l'un de ses ports la première information sous la forme d'un signal électrique à deux niveaux, notamment d'un signal électrique présentant une tension électrique ou une intensité différente de zéro lorsque le dispositif de commutation 15 est dans un premier état et égale à zéro lorsque le dispositif de commutation 15 est dans un deuxième état.

Les deuxièmes informations comportent, par exemple, une première valeur numérique (par exemple « 0 » ou « 1 ») ou textuelle (par exemple « on » ou « off ») dépendant de la première information reçue, et optionnellement un identifiant du module auxiliaire 57, par exemple un numéro de série.

Le contrôleur 80 est, par exemple, configuré pour générer le message lorsqu'un changement d'état du dispositif de commutation 15 est signalé par l'organe de signalisation 50, notamment lorsque le contrôleur 80 détecte un changement de la valeur d'un paramètre (notamment de la tension) du signal électrique reçu.

En variante, le contrôleur 80 est configuré pour générer le message de manière périodique, le message contenant alors des deuxièmes informations représentatives de l'état du dispositif de commutation 15 à un instant de génération du message.

Le contrôleur 80 est, en outre, configuré pour transmettre le message au module de communication 85, par exemple sous forme d'un signal électrique et pour commander la transmission, par le module de communication 85, du message au dispositif de surveillance 20.

Le contrôleur 80 est, par exemple, formé par un processeur et une mémoire contenant des instructions logicielles entraînant la génération du message et la commande de sa transmission lorsque les instructions logicielles sont exécutées par le processeur.

En variante, le contrôleur 80 est formé par un ensemble de composants électroniques dédiés (par exemple sous la forme d'un circuit intégré propre à une application, en Anglais ASIC pour « application-specific integrated circuit »), ou encore par un ensemble de composants logiques programmables.

Le module de communication 85 est configuré pour transmettre le message au dispositif de surveillance 20 via une liaison de données radiofréquence.

Cela signifie que le module de communication 85 est configuré pour convertir le message généré par le contrôleur 80 en un ensemble d'ondes électromagnétiques radiofréquence, et pour transmettre ces ondes électromagnétiques au dispositif de surveillance 20.

Les ondes radiofréquence sont les ondes électromagnétiques présentant une fréquence comprise entre 3 kilohertz (kHz) et 6 gigahertz (GHz).

En particulier, le module de communication 85 est configuré pour convertir le message en un ensemble d'ondes électromagnétiques radiofréquence présentant une fréquence comprise entre 2,4 GHz et 2,483 5 GHz.

Selon un mode de réalisation, le module de communication 85 est configuré pur utiliser un protocole de communication ZigBee. Le protocole ZigBee est défini par la « Zigbee Alliance », et est basé sur le protocole IEEE 802.15.4 défini par l'Institute of Electrical and Electronics Engineers ou IEEE, en français l'«Institut des ingénieurs électriciens et électroniciens ».

Le module de communication 85 comporte une antenne 110.

L'antenne 110 comporte un excitateur 115 et une zone 120 de la première carte de circuit imprimé 100.

L'excitateur 115 est configuré pour générer dans la zone 120 un ensemble d'ondes électromagnétiques destinées à transmettre le message.

L'excitateur 115 est, notamment, interposé selon la direction X d'insertion du module auxiliaire 57 dans l'emplacement 65 entre la zone 120 et la face avant 60 lorsque le module auxiliaire 57 est accueilli dans l'emplacement 65.

Les moyens de réception 90 sont configurés pour recevoir, de l'organe de signalisation 50 de l'emplacement 65 dans lequel le module auxiliaire 57 est accueilli, la première information, et pour la transmettre au contrôleur 80.

Les moyens de réception 90 comportent, par exemple, un circuit électrique et un élément mobile 125.

Le circuit électrique est porté par l'une des deux cartes de circuit imprimé 100, 105, notamment par la deuxième carte de circuit imprimé 105.

Le circuit électrique est électriquement connecté au contrôleur 80.

Le circuit électrique est, par exemple, configuré pour être fermé par l'élément mobile 125. En particulier, le circuit électrique comporte deux portions, reliées chacune au contrôleur 80, l'élément mobile 125 étant prévu pour venir en contact avec les deux portions du circuit pour fermer le circuit.

Le circuit électrique est, par exemple, relié à ses deux extrémités à deux ports du contrôleur 80, le contrôleur 80 étant configuré pour imposer une différence de potentiel entre les deux ports et pour détecter la fermeture ou l'ouverture du circuit en fonction par exemple de variations de la différence de potentiel ou en fonction de la présence ou non d'un courant électrique circulant entre les deux ports.

L'élément mobile 125 s'étend une direction, par exemple la direction d'insertion X du module auxiliaire 57.

L'élément mobile 125 est mobile en translation selon sa direction d'extension, ici la direction X.

L'élément mobile 125 est, notamment, configuré pour être déplacé par l'organe de signalisation 50 entre une première position dans laquelle au moins une partie de l'élément mobile 125 est distant du circuit électrique et une deuxième position dans laquelle l'élément mobile 125 est en contact avec ledit circuit et ferme le circuit.

L'élément mobile 125 est représenté sur la figure 2 dans sa première position.

L'élément mobile 125 comporte, notamment, un doigt mobile 130, un premier ressort 135 et un deuxième ressort 140.

Le doigt mobile 130 s'étend par exemple selon la direction d'extension de l'élément mobile 125, soit ici la direction X.

Le doigt mobile 130 est, notamment, prévu pour traverser une face délimitant le deuxième boîtier 75 selon la direction X, et en particulier une face en regard du fond de l'emplacement 65, i.e la face du deuxième boîtier 75 qui est la plus éloignée de la face avant 60.

Le doigt mobile 130 est réalisé, par exemple, en un matériau électriquement isolant.

Le doigt mobile 130 présente une première extrémité 145 et une deuxième extrémité 150.

La première extrémité 145 est accueillie à l'intérieur du deuxième boîtier 75.

La première extrémité 145 est fixée au premier ressort 135 et au deuxième ressort 140.

La première extrémité 145 comporte au moins un élément électriquement conducteur reliant électriquement le premier ressort 135 au deuxième ressort 140. Cet élément conducteur est, par exemple, formé par un doigt reliant les ressorts 135, 140 entre eux. Le doigt est, notamment, venu de matière avec l'un de ces deux ressorts 135, 140, par exemple.

De manière connue en soi, la première extrémité 145 comporte optionnellement un ou des éléments contribuant à maintenir en position le premier ressort 135 et le deuxième ressort 140 par rapport à la première extrémité 145.

La deuxième extrémité 150 est située à l'extérieur du deuxième boîtier 75.

La deuxième extrémité 150 est configurée pour être en appui contre l'organe de signalisation 50, de manière à ce que le déplacement de l'organe de signalisation 50 selon la direction X applique sur la deuxième extrémité 150 une force tendant à déplacer l'élément mobile 125 depuis la première position jusqu'à la deuxième position.

Le premier ressort 135 est en appui contre la première extrémité 145 et contre la deuxième carte de circuit imprimé 105. En particulier, le premier ressort 135 est en contact avec une portion du circuit électrique porté par la deuxième carte de circuit imprimé 105.

Le premier ressort 135 exerce sur la première extrémité 145 une force tendant à éloigner la première extrémité 145 de la deuxième carte de circuit imprimé 105.

Le premier ressort 135 s'étend selon la direction selon laquelle l'élément mobile 125 est prévu pour se déplacer, ici la direction X.

Une extrémité du deuxième ressort 140 est fixé à la première extrémité 145.

Le deuxième ressort 140 s'étend selon la direction selon laquelle l'élément mobile 125 est prévu pour se déplacer, ici la direction X.

Le deuxième ressort 140 est configuré pour, lorsque l'élément mobile 125 est dans la première position, l'extrémité du deuxième ressort 140 qui n'est pas fixée à la première extrémité 145 n'est pas en contact avec la deuxième carte de circuit imprimé 105, et notamment pas en contact électrique avec le circuit électrique porté par cette carte 105. Ainsi, lorsque l'élément mobile 125 est dans la première position, le circuit électrique est ouvert et aucun courant électrique ne circule entre les deux ports correspondants du contrôleur 80.

Lorsque l'élément mobile 125 est dans la deuxième position, l'extrémité du deuxième ressort 140 qui n'est pas fixée à la première extrémité 145 est en contact avec la deuxième carte de circuit imprimé 105, et notamment en contact électrique avec le circuit électrique porté de manière à fermer le circuit.

Ainsi, lorsque l'élément mobile 125 est dans la deuxième position, un courant électrique peut circuler entre les deux bornes correspondantes du contrôleur, en traversant successivement une portion du circuit, le premier ressort 135, l'élément conducteur porté par la première extrémité 145, le deuxième ressort 140 et l'autre portion du circuit électrique.

L'organe de stockage 95 est configuré pour stocker de l'énergie électrique, et pour alimenter électriquement le contrôleur 80 et le module de communication 85 avec un courant électrique d'alimentation généré à partir de l'énergie électrique stockée.

L'organe de stockage 95 s'étend dans un plan d'extension, ce plan étant notamment parallèle au plan formé par les directions X et Z. En particulier, une épaisseur de l'organe de stockage 95 selon la direction Y est, par exemple, au moins deux fois inférieure à une extension maximale de l'organe de stockage dans une direction de son plan d'extension.

L'organe de stockage 95 présente une face latérale 155 et deux faces terminales 160.

La face latérale 155 délimite l'organe de stockage 95 dans son plan d'extension. La face latérale 155 est, par exemple, cylindrique et présente un axe central perpendiculaire au plan d'extension, donc ici parallèle à la direction Y.

Les faces terminales 160 s'étendent chacune parallèlement au plan d'extension de l'organe de stockage 95 et, ensemble, délimitent l'organe de stockage 95 selon la direction Y.

L'organe de stockage 95 comporte un premier contact électrique et un deuxième contact électrique, et est configuré pour imposer une tension électrique entre le premier contact et le deuxième contact de manière à générer le courant électrique d'alimentation.

Le premier contact est porté par la face latérale 155. Par exemple, le premier contact est formé par une portion ou par la totalité de la face latérale 155, auquel cas la face latérale 155 est réalisée en un matériau électriquement conducteur.

Le deuxième contact est porté par l'une des faces terminales 160, par exemple formé par l'une des faces terminales 160, réalisée dans ce cas en un matériau électriquement conducteur.

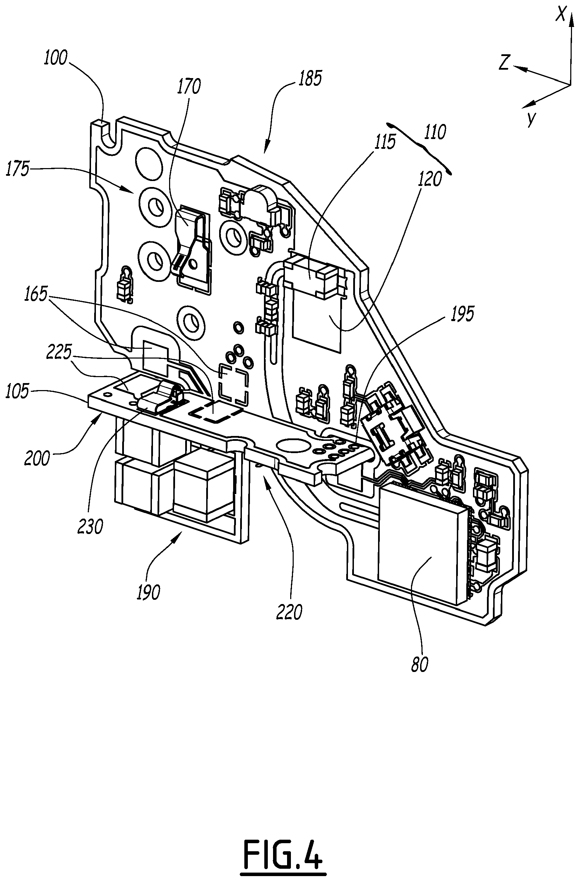

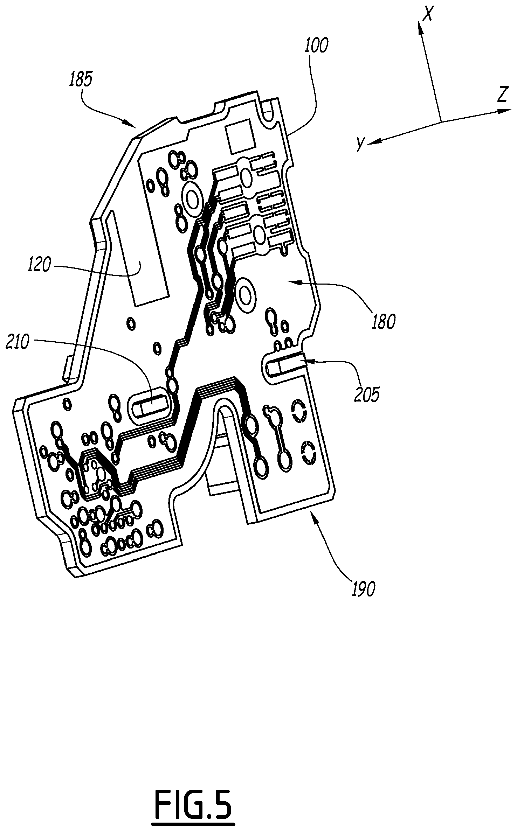

La première et la deuxième carte de circuit imprimé 100, 105 du premier exemple de module auxiliaire 57 sont représentés en perspective, ainsi que les éléments portés dans ces deux cartes 100, 105, selon deux points de vue différents sur les figures 4 et 5.

Il est notamment entendu par « carte de circuit imprimé » 100, 105 (en Anglais « Printed Circuit Board ») une carte sensiblement plane comportant au moins une plaque d'un matériau électriquement isolant portant au moins une couche d'un matériau électriquement conducteur, chaque couche couvrant partiellement une face de la plaque de manière à connecter électriquement un ensemble d'éléments, notamment de composants électroniques et de contacts électriques.

Chaque plaque est, par exemple, réalisée en un matériau composite, notamment comportant un ensemble de fibres de verre prises dans une matrice d'une résine epoxy ou d'une matière plastique, ou encore d'un matériau composite tel que FR4 ou d'un polyimide.

Chaque carte de circuit imprimé 100, 105 comporte, notamment, un ensemble de plaques superposées selon une direction perpendiculaire au plan dans lequel la carte 100, 105 s'étend, une couche conductrice étant interposée entre chacune des plaques et les plaques contigües, chaque face délimitant la carte 100, 105 selon la direction précitée comportant également une couche correspondante, les différentes couches étant reliées les unes aux autres par des vias traversant chacune une ou plusieurs plaques.

Chaque carte de circuit imprimé 100, 105 présente, par exemple, une épaisseur (mesurée selon une direction perpendiculaire au plan d'extension de la carte 100, 105 considérée) comprise entre 0,5 millimètres (mm) et 5 mm, notamment égale à 0,8 mm.

Chaque couche conductrice présente une épaisse comprise, par exemple, entre 10 micromètres (µm) et 50 µm, notamment égale à 35 µm.

La première carte de circuit imprimé 100 s'étend dans un plan parallèle à la direction selon laquelle le module auxiliaire 57 est configuré pour être inséré ou extrait de l'emplacement 65, en particulier dans un plan parallèle aux directions X et Z.

Notamment, le plan d'extension de la première carte de circuit imprimé 100 est parallèle au plan d'extension de l'organe de stockage 95.

La première carte de circuit imprimé 100 porte le contrôleur 80 et le module de communication 85, notamment l'excitateur 115 de l'antenne 110.

La première carte de circuit imprimé 100 porte, en outre, au moins deux premières plages de connexion 165, par exemple trois premières plages de connexion 165, et un troisième contact électrique 170, ainsi qu'un ensemble de composants électriques ou électroniques, ces derniers n'étant pas décrits car ils sont susceptibles de varier d'un mode de réalisation à un autre.

La première carte de circuit imprimé 100 présente une première face 175 (visible sur la figure 4) et une deuxième face 180 (visible sur la figure 5), ainsi qu'une troisième extrémité 185 et une quatrième extrémité 190.

Les faces 175 et 180 délimitent la première carte de circuit imprimé 100 selon la direction Y, les extrémités 185 et 190 délimitent la première carte de circuit imprimé 100 selon la direction X, c'est-à-dire la direction selon laquelle le module auxiliaire 57 est prévu pour être extrait de l'emplacement 65 ou inséré dans l'emplacement 65.

La première face 175 porte le contrôleur 80, l'excitateur 85, et le troisième contact électrique 170.

La zone 120 est une zone de la première carte 100 dépourvue de métal. En particulier les différentes faces des plaques de la première carte 100 sont chacune dépourvue de métal, notamment des couches précitées, dans la zone 120. Les faces 175 et 180 sont donc dépourvues de métal dans la zone 120.

La zone 120 présente, par exemple, dans le plan d'extension de la carte 100, une forme rectangulaire ou carrée.

La zone 120 présente, par exemple, dans le plan d'extension de la carte 100, des côtés dont la longueur est comprise entre 4 mm et 4,5 mm.

La zone 120 est, notamment, entourée dans le plan d'extension de la carte 100 par un ensemble d'éléments électriquement conducteurs traversant la première carte 100 selon une direction perpendiculaire au plan d'extension de la première carte 100, ici la direction Y, et chacun reliés à la masse du module auxiliaire 57.

Les éléments conducteurs traversant la première carte 100 sont, par exemple, disposés le long d'un contour délimitant au moins partiellement la zone 120 dans le plan d'extension de la carte 100, une distance entre deux éléments conducteurs successifs étant comprise, par exemple, entre 1 et 3 millimètres.

L'antenne 110 est disposée à la troisième extrémité 185 de la première carte de circuit imprimé 100.

La troisième extrémité 185 est, parmi les extrémités 185 et 190, la plus proche de la face avant 60 du dispositif de commutation 15 lorsque le module auxiliaire 57 est accueilli dans un emplacement 65.

En particulier, une distance, selon la direction X d'insertion du module auxiliaire 57, entre l'excitateur 115 et la face avant 60, est comprise entre 5 mm et 10 mm.

Une longueur de la première carte de circuit imprimé 100, mesurée entre les extrémités 185 et 190 selon la direction X, est par exemple comprise entre 20 mm et 30 mm, notamment entre 26 mm et 27 mm.

Chaque première plage de connexion 165 est portée, par exemple, par la première face 175.

Chaque première plage de connexion 165 est électriquement connectée au contrôleur 80.

En particulier, deux des premières plages de connexion 165 sont prévues pour être électriquement connectées au circuit des moyens de réception 90, et électriquement connectées à deux ports du contrôleur 80 de manière à connecter ces ports audit circuit.

Une autre première plage de connexion 165 est également connectée au contrôleur 80 et est prévue pour recevoir, de la deuxième carte 105, le courant d'alimentation généré par l'organe de stockage 95, et pour transmettre ce courant au contrôleur 80 et/ou au module de communication 85, directement ou indirectement.

Chaque première plage de connexion 165 est formée par une couche d'un matériau électriquement conducteur portée par la première face 175 ou par la deuxième face 180, selon les cas. Cette couche est notamment une portion des couches précitées déposées sur chaque face des plaques ou interposées entre deux plaques contigües.

Le matériau électriquement conducteur est, notamment, du cuivre.

Chaque première plage de connexion 165 présente, par exemple, une surface comprise entre 1 mm² et 10 mm², notamment égale à 4 mm².

Chaque première plage de connexion 165 est, par exemple, rectangulaire dans le plan d'extension de la première carte 100.

Chaque première plage de connexion 165 est, par exemple, traversée par au moins un élément de renfort 195.

Chaque élément de renfort 195 s'étend selon la direction perpendiculaire au plan d'extension de la première carte de circuit imprimé 100, ici la direction Y.

Chaque élément de renfort 195 traverse la première carte de circuit imprimé 100 et débouche sur ses deux faces 175, 180. En outre, chaque élément de renfort 195 présente deux extrémités, chaque extrémité formant une saillie à partir de la face 175, 180.

Chaque élément de renfort 195 est accueilli dans une via, c'est-à-dire un trou traversant au moins partiellement, dans le cas présent totalement, la première carte de circuit imprimé 100 selon la direction Y.

Chaque élément de renfort 195 est, par exemple, un tube s'étendant selon la direction Y et présentant à chacune de ses extrémités une collerette de diamètre extérieur plus grand que la portion de l'élément de renfort 195 qui est interposée entre les deux collerettes selon la direction Y.

Chaque élément de renfort 195 présente, par exemple, dans sa portion centrale qui est entièrement accueillie dans la via correspondante, un diamètre extérieur compris entre 0,3 mm et 0,4 mm, notamment égal au diamètre de la via, ce dernier étant, par exemple, égal à 0,35 mm. Le diamètre intérieur de la portion centrale est, par exemple, compris entre 0,2 mm et 0,3 mm.

Le diamètre externe de chaque collerette est strictement supérieur au diamètre de la via, et est par exemple compris entre 0,4 mm et 0,6 mm, notamment égal à 0,50 mm, à 0,05mm près.

La collerette faisant saillie à partir de la face première 175 forme également une saillie à parti de la première plage de connexion 165 que l'élément de renfort 195 traverse.

Chaque élément de renfort 195 est, par exemple, obtenu en déposant un matériau métallique, notamment du cuivre, dans la via correspondante. De tels dépôts sont connus en soi pour connecter électriquement des portions de couches conductrices portées par des plaques différentes ou par des faces différentes d'une même plaque d'une carte de circuit imprimé.

Le troisième contact électrique 170 est prévu pour que le deuxième contact électrique de l'organe de stockage 95 vienne en appui contre le troisième contact électrique 170, et pour connecter électriquement le deuxième contact électrique au moins au contrôleur 80.

Le troisième contact électrique 170 est, par exemple, une pièce métallique formée par une plaque pliée de manière à être déformable par l'appui de l'organe de stockage 95 contre le troisième contact électrique 170. Ainsi, le troisième contact électrique 170 assure une bonne connexion électrique entre le troisième contact 170 et le deuxième contact, tout en permettant un peu de jeu entre l'organe de stockage 95 et la première carte de circuit imprimé 100.

La face terminale 160 qui forme le deuxième contact électrique vient notamment en appui contre le troisième contact 170 de manière à exercer sur celui-ci une force orientée selon la direction X.

La deuxième carte de circuit imprimé 105 s'étend à partir de la première carte de circuit imprimé 100 selon une direction sensiblement perpendiculaire au plan d'extension (X, Z) de la première carte 100.

Par exemple, la deuxième carte 105 s'étend dans un plan perpendiculaire à la direction X.

En particulier, la deuxième carte de circuit imprimée 105 s'étend, selon la direction Y, entre une cinquième extrémité 200 et une sixième extrémité 205.

Il est notamment entendu par « s'étendre selon une direction sensiblement perpendiculaire au plan d'extension (X, Z) de la première carte 100 » que l'extrémité 200 est décalée, selon la direction Y, par rapport à la première carte 100, la deuxième carte 105 étant en contact avec la première carte 100 au moins en un point, sans que la deuxième carte 105 soit nécessairement perpendiculaire à la direction X.

La deuxième carte de circuit imprimé 105 est fixée à la première carte 100.

Au moins une portion de la deuxième carte 105, interposée entre les extrémités 200 et 205, est par exemple accueillie dans un trou traversant la première carte 100 selon la direction Y.

En variante, comme représenté sur la figure 5, la sixième extrémité 205 comporte une ou plusieurs projections 210 accueillies chacune dans un trou correspondant.

Ainsi, une fixation du type « tenon et mortaise » est obtenue entre la première carte de circuit imprimé 100 et la deuxième carte de circuit imprimé 105.

La ou les portions de la deuxième carte 105 qui sont insérée(s) dans un ou plusieurs trous correspondants de la première carte 100 est (sont) notamment configurée(s) pour, lorsqu'elle(s) est (sont) insérée(s) dans le ou les trous correspondant(s), empêcher une translation dans le plan d'extension de la première carte 100 entre les cartes 100 et 105.

Chaque trou accueillant une portion de la deuxième carte 105 délimite, par exemple, l'une ou plusieurs des premières plages de connexion 165 dans le plan d'extension de la première carte 100.

Une distance, selon la direction Y, entre la première carte de circuit imprimé 100 et la cinquième extrémité 200 est, par exemple, inférieure ou égale à 20 mm, notamment inférieure à égale à 15 mm, en particulier égale à 8,5 mm.

La deuxième carte de circuit imprimé 105 présente une troisième face 215 et une quatrième face 220 qui, ensemble, délimitent la deuxième carte 105 selon la direction X.

Parmi les faces 215 et 220, la troisième face 215 est la plus proche de la face avant 60 lorsque le module auxiliaire 57 est accueilli dans un emplacement 65. La quatrième face 220 est, elle, en regard de l'élément mobile 125, qui est configuré pour venir en appui contre la quatrième face 220 lorsque l'élément mobile 125 est dans la deuxième position. Notamment, le deuxième ressort 140 vient en appui contre la quatrième face 220. Le circuit électrique est, en particulier, porté par la quatrième face 220.

La deuxième carte de circuit imprimé 105 porte le circuit électrique précité (qui interagit avec l'élément mobile 125), au moins deux deuxièmes plages de connexion 225, notamment trois deuxièmes plages de connexion 225 et un quatrième contact électrique 230.

Chaque deuxième plage de connexion 225 est formée par une couche d'un matériau électriquement conducteur portée par la troisième face 215 ou la quatrième face 220, selon les cas. Cette couche est notamment une portion des couches précitées déposées sur chaque face des plaques ou interposées entre deux plaques contigües.

Le matériau électriquement conducteur est, notamment, du cuivre.

En particulier, chacune des faces 215 et 220 porte au moins une deuxième plage de connexion 225. Par exemple, comme visible sur la figure 4, la face 215 porte deux deuxièmes plages de connexion 225 et la face 220 porte au moins une deuxième plage de connexion 225.

Chaque deuxième plage de connexion 225 présente, par exemple, une surface comprise entre 3 mm² et 10 mm², notamment égale à 6 mm².

Chaque deuxième plage de connexion 225 est, par exemple, rectangulaire dans le plan d'extension de la deuxième carte 105.

Chaque deuxième plage de connexion 225 est, par exemple, traversée par un ou des éléments de renfort 195 traversant la deuxième carte 105 selon la direction X, ce ou ces élément(s) de renfort étant notamment identiques à ceux des premières plages 165.

Chaque deuxième plage de connexion 225 est configurée pour être électriquement connectée à une première plage de connexion 165 correspondante.

Chaque deuxième plage de connexion 225 est, notamment, délimitée dans le plan d'extension de la deuxième carte 105 par la première plage de connexion 165 correspondante lorsque la deuxième carte 105 est insérée dans la ou les trous de la première carte 100. Ainsi, la deuxième plage de connexion 225 et la première plage de connexion 165 correspondante forment, ensemble, une équerre.

Selon un mode de réalisation, chaque deuxième plage de connexion 225 est soudée à la première plage de connexion 165 correspondante par une masse de métal.

Le métal est, par exemple, un alliage à base d'étain.

Chaque masse de métal est, notamment, fixée directement à la deuxième plage de connexion 225 et à la première plage de connexion 165 de manière à solidariser la deuxième plage de connexion 225 et la première plage de connexion 165.

En outre, chaque masse de métal est solidaire des éléments de renfort 195 des plages 165, 225 auxquelles la masse est fixée, notamment de la collerette, dépassant de chaque plage 165, 225, de chaque élément de renfort 195.

Deux des deuxièmes plages de connexion 225 sont, par exemple, chacune reliée à une extrémité du circuit électrique que l'élément mobile 125 est prévu pour fermer. Ces deux deuxièmes plages 225 sont connectées chacune à un port du contrôleur 80 par une première plage de connexion 165 correspondante.

Une troisième deuxième plage 225 est électriquement connectée, par la ou les couches conductrices de la deuxième carte 105, au quatrième contact électrique 230, de manière à relier le quatrième contact électrique 230 au contrôleur 80 et/ou au module de communication 85 via une plage 165 correspondante. Ainsi, l'organe de stockage 95 alimente électriquement les différents éléments du module auxiliaire 57, notamment le contrôleur 80 et le module de communication 85, via le contact 230 et la deuxième plage 225 correspondante.

Le quatrième contact 230 est électriquement connecté, notamment en appui, contre le premier contact électrique de l'organe de stockage 95.

Le quatrième contact 230 est porté, par exemple, par la face 215.

Le quatrième contact 230 est, par exemple, formé par un ou plusieurs éléments métalliques flexibles conçus pour se déformer lorsque l'organe de stockage 95 est en appui contre le quatrième contact 230.

Le quatrième contact 230 est, notamment, configuré pour exercer sur l'organe de stockage 95 une force tendant à déplacer l'organe de stockage 95 dans le plan formé par les directions X et Z, par exemple selon la direction X.

Le dispositif de surveillance 20 est distant du dispositif de commutation 15. En particulier, le dispositif de surveillance 20 n'est pas en contact avec le dispositif de commutation15. De plus, le dispositif de surveillance 20 comporte, par exemple, un boîtier distinct et distant du premier boîtier 60.

Une distance entre les dispositifs 15 et 20 est, par exemple, inférieure ou égale à 100 mètres.

Le dispositif de surveillance 20 est configuré pour recevoir les messages émis par chaque module auxiliaire 57 et pour indiquer chaque état du ou des dispositif(s) de commutation 15 à un opérateur.

Le dispositif de surveillance 20 comporte, par exemple, un récepteur radiofréquence 235, une interface homme-machine 240 et un écran d'affichage 245.

Le récepteur 235 est configuré pour recevoir chaque message généré par le ou les module(s) de communication 85 du ou des module(s) auxiliaire(s) 57.

L'interface homme-machine 240 est propre à permettre à l'opérateur d'échanger des informations avec le dispositif de surveillance 20, par exemple pour commander l'affichage, par l'écran 245, de l'état d'un dispositif de commutation 15 spécifique parmi l'ensemble des dispositifs de commutation 15.

Grâce à l'utilisation d'une liaison de données radiofréquence, il n'est plus nécessaire de prévoir des passages dédiés pour les conducteurs électriques reliant le module auxiliaire au dispositif de surveillance, et le risque de perte de communication entre le module auxiliaire et le dispositif de surveillance est réduit puisqu'il n'est alors plus sensible à l'endommagement d'un conducteur électrique. Le module auxiliaire est donc à la fois plus facile à intégrer et plus sécurisé.

L'utilisation de deux cartes de circuit imprimé 100 et 105 dont l'une s'étend selon une direction perpendiculaire à l'autre carte, permet à cette carte 105 d'interagir de manière simple avec l'organe mobile 125 pour permettre l'indication, par celui-ci, de l'état du dispositif de commutation 15, tout en permettant à l'autre carte 100 d'être positionnée plus aisément dans le module auxiliaire 57. Ainsi, les différents éléments portés par les cartes 100 et 105 (contrôleur 80, module de communication 85, contacts 170 et 230 éventuels) peuvent être répartis sur ces deux cartes 100 et 105 de manière à pouvoir choisir ou adapter les dimensions respectives de ces cartes 100 et 105 pour en faciliter l'intégration dans le deuxième boîtier 75.

En particulier, lorsque la deuxième carte 105 est perpendiculaire à la direction X selon laquelle le module auxiliaire 57 est prévu pour être inséré ou extrait de l'emplacement 65, l'organe mobile 125 peut alors s'étendre selon cette même direction X pour ainsi être aisément actionné par les moyens d'actionnement sans que soit l'organe mobile 125 soit les moyens d'actionnement ne fassent obstacle à une insertion du module auxiliaire 57 dans l'emplacement 65. De plus, l'organe mobile 125 vient alors de manière fiable ouvrir ou fermer le circuit porté par la carte 105.

L'utilisation d'une ou plusieurs projections de la deuxième carte 105 insérée(s) dans la première carte 100 pour en empêcher la translation par rapport à la première carte 100 permet d'assurer leur solidarisation de manière simple et efficace, notamment pour résister aux efforts appliqués par l'organe mobile 125 selon la direction X sur la carte 105.

Le fait de souder l'une à l'autre les plages 165 et 225 correspondantes permet également de maintenir en position les deux cartes 100 et 105 l'une par rapport à l'autre, et notamment pour éviter que ces deux cartes pivotent l'une par rapport à l'autre sous l'effet de la force exercée par l'organe 105.

Lorsque les deux faces de la deuxième carte 105 portent chacune au moins une deuxième plage 225 soudée à la plage 165 correspondante, la tenue mécanique des deux cartes 100, 105 l'une par rapport à l'autre est notamment améliorée.

La présence des éléments de renfort 195 dans des vias débouchant sur les plages 165, 225 permet de renforcer la tenue mécanique puisque la masse de métal utilisée pour la soudure n'est pas seulement solidaire des plages 165 et 225, qui sont constituées de couches de métal relativement fines, mais aussi des éléments de renfort 195 qui traversent toute la carte 100, 105. Ainsi, l'effort est réparti sur toute l'épaisseur de la carte 100, 105 et non seulement sur la plage 165, 225, et le risque d'arrachement de cette dernière est donc grandement réduit.

La présence des deux cartes 100 et 105 s'étendant selon des directions différentes l'une de l'autre permet aussi de connecter aisément les deux contacts de l'organe de stockage 95, pour de nombreuses configurations d'organes de stockage 95, notamment s'ils sont portés par des faces 155, 160 perpendiculaires l'une à l'autre de l'organe de stockage 95. En particulier, pour des organes 95 relativement plats, cela facilite leur orientation parallèle au plan (X, Z), ce qui participe à réduire l'épaisseur selon la direction Y du module auxiliaire 57. Ainsi, puisque les dispositifs de commutation 15 sont en général prévus pour que les conducteurs et les mécanismes 40 qu'ils comportent s'étendent selon la direction Z, les modules auxiliaires 57 peuvent être insérés aisément entre ces différents éléments. Bien évidemment, l'intérêt d'obtenir des modules 57 fins reste vérifié quelle que soit l'orientation des mécanismes 40.

Des antennes 110 comportant un excitateur 115 et une zone 120 sans métal permettent d'obtenir un rayonnement électromagnétique relativement isotrope et ainsi d'éviter que la fiabilité de la communication avec le dispositif 20 dépende excessivement de son positionnement relatif au dispositif de commutation 15. Cela est en particulier vrai lorsque l'excitateur 115 est disposé entre la zone 120 et la face avant 60.

Lorsque l'antenne 110 est portée par l'extrémité 185, la communication est rendue plus fiable malgré la présence des conducteurs et organes de commutation 40 métalliques.

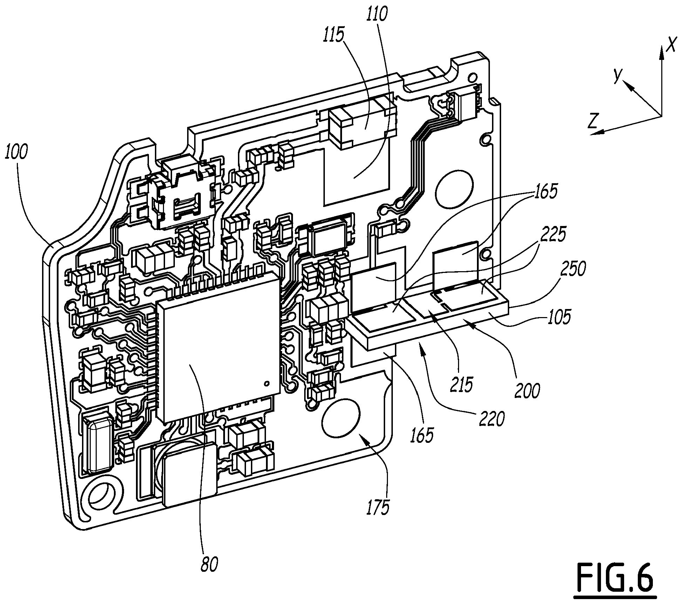

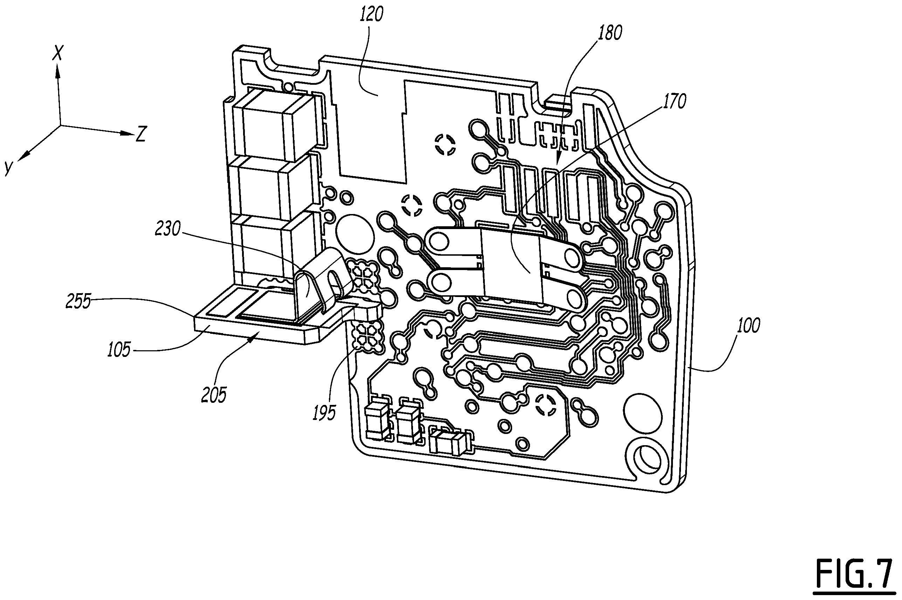

Un deuxième exemple de module auxiliaire 57 selon l'invention va maintenant être décrit, en référence aux figures 6 et 7, qui montrent les cartes 100 et 105 ainsi que les éléments qu'elles portent, notamment le contrôleur 80 et l'antenne 110.

Les éléments identiques au premier exemple ne sont pas décrits à nouveau, seules les différences sont mises en évidence.

Une portion 250 de la deuxième carte 105 s'étend d'un côté de la première carte 100, une autre portion 255 s'étend d'un autre côté de la carte 100.

Par exemple, la portion 250 s'étend selon la direction Y à partir de la face 175 qui porte le contrôleur 80 et le module de communication 85. La portion 250 porte, par exemple, les plages 225.

La portion 255 s'étend selon la direction Y à partir de la face 180. La portion 255 porte, par exemple, le quatrième contact électrique 230.

Il est ainsi observé que de nombreuses configurations des cartes 100 et 105 sont possibles.

De manière générale, la répartition des différents éléments portés par les cartes 100 et 105 est susceptible de varier selon les besoins.

De plus, bien que des modes de réalisation comportant deux cartes 100 et 105 aient été décrits en détails ici, d'autres modes de réalisation sans cartes de circuit imprimé ou avec une seule carte sont également envisageables.

## Revendications

1. Module auxiliaire (57) pour un dispositif de commutation électrique (15), le dispositif de commutation électrique (15) comprenant au moins une entrée (30), une sortie (35), un premier boîtier (25) et un module de commutation (40) configuré pour commuter entre une première configuration dans laquelle le module de commutation (40) permet le passage d'un courant électrique entre l'entrée (30) et la sortie (35) et une deuxième configuration dans laquelle le module de commutation (40) empêche le passage du courant entre l'entrée (30) et la sortie (35), le premier boîtier (25) délimitant une chambre (55) accueillant le module de commutation (40), le premier boitier (25) délimitant en outre un emplacement (65) de réception du module auxiliaire (57), l'emplacement (65) comportant au moins un organe de signalisation (50) configuré pour transmettre au module auxiliaire (57) une première information relative à un état du dispositif de commutation (15) électrique lorsque le module auxiliaire (57) est accueilli dans l'emplacement (65),
le module auxiliaire (57) comprenant un contrôleur (80) configuré pour générer un message contenant des deuxièmes informations représentatives de la première information transmise, et un module de communication radiofréquence (85) configuré pour transmettre le message, via une liaison de données radiofréquence, à un dispositif (20) distant du dispositif de commutation électrique (15),
le module auxiliaire (57) étant **caractérisé en ce qu'**il comprend un deuxième boîtier (75), une première carte (100) de circuit imprimé, une deuxième carte (105) de circuit imprimé et un élément mobile (125), le deuxième boîtier (75) délimitant une chambre accueillant la première carte (100) et la deuxième carte (105), la première carte de circuit imprimé (100) portant le contrôleur (80) et s'étendant dans un premier plan, la deuxième carte de circuit imprimé (105) étant connectée à la première carte de circuit imprimé (100) et s'étendant à partir de la première carte de circuit imprimé (100) selon une direction perpendiculaire au premier plan, la deuxième carte de circuit imprimé (105) portant un circuit électrique connecté au contrôleur (80), l'élément mobile (125) étant configuré pour être déplacé en translation par l'organe de signalisation (50) selon une direction de translation (X) entre une première position dans laquelle le circuit électrique est ouvert et une deuxième position dans laquelle l'élément mobile (125) ferme le circuit électrique, l'état du dispositif de commutation (15) étant indiqué par l'état ouvert ou fermé dudit circuit électrique.

2. Module auxiliaire selon la revendication 1, dans lequel la direction de translation (X) est perpendiculaire à un deuxième plan d'extension de la deuxième carte de circuit imprimé (105), la direction de translation (X) étant notamment une direction selon laquelle le module auxiliaire (57) est propre à être inséré dans l'emplacement (65) ou extrait de l'emplacement (65).

3. Module auxiliaire selon la revendication 1 ou 2, dans lequel la deuxième carte de circuit imprimé (105) comporte au moins une projection (210) insérée dans un trou traversant la première carte de circuit imprimé (100) de manière à empêcher une translation relative des deux cartes de circuit imprimé (100, 105) l'une par rapport à l'autre dans le premier plan.

4. Module auxiliaire selon l'une quelconque des revendications 1 à 3, dans lequel la première carte de circuit imprimé (100) porte au moins deux premières plages (165) de connexion et la deuxième carte de circuit imprimé (105) porte au moins deux deuxièmes plage (225) de connexion, chaque première ou deuxième plage (165, 225) étant portée par une face (175, 180, 215, 220) de la carte (100, 105) correspondante, chaque deuxième plage (225) étant connectée à une des premières plages de connexion (165) pour permettre à un courant électrique de circuler entre la première plage de connexion (165) et la deuxième plage de connexion (225), les deux deuxièmes plages (225) ou deux des deuxièmes plages (225) étant reliées audit circuit électrique, chaque première plage (165) étant soudée à la deuxième plage (225) correspondante par une masse de métal électriquement conducteur.

5. Module auxiliaire selon la revendication 4, dans lequel la deuxième carte de circuit imprimé (105) présente deux faces (215, 220) délimitant la deuxième carte (105) selon une direction (X) perpendiculaire au deuxième plan, chacune des deux faces (215, 220) de la deuxième carte (105) portant au moins une des deuxièmes plages (225) de connexion.

6. Module auxiliaire selon la revendication 5, dans lequel chaque carte de circuit imprimé (100, 105) comporte, pour au moins une des premières ou deuxièmes plages (165, 225) de la carte (100, 105) considérée, un ensemble de vias traversant la carte (100, 105) selon une direction perpendiculaire au premier ou deuxième plan d'extension de la carte (100, 105) considérée, chaque via débouchant à travers la première ou deuxième plage (165, 225) et contenant un élément métallique (195) traversant la carte de circuit imprimé (100, 105) considérée.

7. Module auxiliaire selon l'une quelconque des revendications 1 à 6, comportant un organe (95) de stockage d'énergie électrique prévu pour alimenter électriquement le contrôleur (80) et le module de communication (85), l'organe de stockage (95) s'étendant dans un troisième plan parallèle au premier plan et présentant au moins une face latérale (155) délimitant l'organe de stockage (95) dans le troisième plan, l'organe de stockage (95) comportant un premier contact électrique et un deuxième contact électrique et étant configuré pour imposer une tension électrique entre le premier contact et le deuxième contact, la face latérale (155) portant le premier contact électrique, le premier contact électrique étant connecté à un troisième contact électrique (230) porté par la deuxième carte de circuit imprimé (105), le troisième contact électrique (230) étant relié au contrôleur (80) et au module de communication (85) via l'une des deuxièmes plages de connexion (225), les deuxièmes plages de connexion (225) étant au nombre de trois ou plus.

8. Module auxiliaire selon la revendication 7, dans lequel la première carte de circuit imprimé (100) comporte un quatrième contact électrique (170) relié au contrôleur (80) et au module de communication (85), le deuxième contact électrique étant en appui contre le quatrième contact électrique (170).

9. Module auxiliaire selon l'une quelconque des revendications précédentes, dans lequel le module de communication (85) comporte une antenne (110), l'antenne (110) comportant une zone (120) dépourvue de revêtement métallique de la première carte de circuit imprimé (100) et un excitateur (115) configuré pour générer au moins une onde électromagnétique dans ladite zone (120).

10. Module auxiliaire selon la revendication 9, prévu pour un dispositif de commutation (15) dont le premier boîtier (25) présente une face avant (60) prévue pour être accessible par un opérateur lorsque le dispositif de commutation (15) est en fonctionnement, dans lequel, lorsque le module auxiliaire (57) est accueilli dans ledit emplacement (65), l'excitateur (115) est interposé entre ladite zone (120) et la face avant (60).

11. Module auxiliaire selon la revendication 9 ou 10, prévu pour un dispositif de commutation (15) dont le premier boîtier (25) présente une face avant (60) prévue pour être accessible par un opérateur lorsque le dispositif de commutation (15) est en fonctionnement, dans lequel la première carte de circuit imprimé (100) présente une première extrémité (185) et une deuxième extrémité (190), la première extrémité (185) et la deuxième extrémité (190) délimitant ensemble la première carte (100) selon une direction (X) perpendiculaire à la face avant (60), la première extrémité (185) étant, parmi la première extrémité (185) et la deuxième extrémité (190), l'extrémité (185, 190) la plus proche de la face avant (60), dans lequel l'antenne (110) est portée par la première extrémité (185).

12. Dispositif de commutation électrique comportant au moins une entrée (30), une sortie (35), un premier boîtier (25), un module auxiliaire (57) selon l'une quelconque des revendications 1 à 11 et un module de commutation (40) configuré pour commuter entre une première configuration dans laquelle le module de commutation (40) permet le passage d'un courant électrique entre l'entrée (30) et la sortie (35) et une deuxième configuration dans laquelle le module de commutation (40) empêche le passage du courant entre l'entrée (30) et la sortie (35), le premier boîtier (25) délimitant une chambre (55) accueillant le module de commutation (40), le premier boitier (25) délimitant en outre un emplacement (65) de réception du module auxiliaire (57), l'emplacement (65) comportant au moins un organe de signalisation (50) configuré pour transmettre au module auxiliaire (57) une première information relative à un état du dispositif de commutation électrique (15) lorsque le module auxiliaire (57) est accueilli dans l'emplacement (65).

13. Dispositif de commutation électrique selon la revendication 12, dans lequel le premier boîtier (25) délimite une pluralité d'emplacements de réception (65) configurés chacun pour accueillir un module auxiliaire (57) selon l'une quelconque des revendications 1 à 12, chaque emplacement de réception (65) étant associé à un état respectif du dispositif de commutation électrique (15), différent de l'état associé à chaque autre emplacement de réception (65), chaque emplacement de réception (65) comprenant un organe de signalisation (50) respectif configuré pour transmettre à un module auxiliaire (57) une première information relative à l'état associé lorsque le module auxiliaire (57) est accueilli dans l'emplacement de réception (65).

14. Système de surveillance d'une installation électrique, comportant au moins un dispositif de commutation (15) selon la revendication 12 ou 13 et un dispositif de surveillance (20) configuré pour recevoir chaque message transmis par le ou les module(s) auxiliaires (57).

## Patentansprüche

1. Hilfsmodul (57) für eine elektrische Schaltvorrichtung (15), die elektrische Schaltvorrichtung (15) umfassend mindestens einen Eingang (30), einen Ausgang (35), ein erstes Gehäuse (25) und ein Schaltmodul (40), das konfiguriert ist, um zwischen einer ersten Konfiguration, in der das Schaltmodul (40) den Fluss eines elektrischen Stroms zwischen dem Eingang (30) und dem Ausgang (35) zulässt, und einer zweiten Konfiguration, in der das Schaltmodul (40) den Fluss des Stroms zwischen dem Eingang (30) und dem Ausgang (35) verhindert, umzuschalten, wobei das erste Gehäuse (25) eine Kammer (55) begrenzt, die das Schaltmodul (40) aufnimmt, das erste Gehäuse (25) ferner einen Steckplatz (65) zum Aufnehmen des Hilfsmoduls (57) begrenzt, wobei der Steckplatz (65) mindestens ein Signalisierungselement (50) umfasst, das konfiguriert ist, um dem Hilfsmodul (57) erste Informationen in Bezug auf einen Zustand der elektrischen Schaltvorrichtung (15) zu übertragen, wenn das Hilfsmodul (57) in dem Steckplatz (65) aufgenommen ist.
das Hilfsmodul (57) umfassend eine Steuerung (80), die konfiguriert ist, um eine Nachricht zu erzeugen, die zweite Informationen enthält, die repräsentativ für die übertragenen ersten Informationen sind, und ein Hochfrequenz-Kommunikationsmodul (85), das konfiguriert ist, um die Nachricht über eine Hochfrequenz-Datenverbindung an eine Vorrichtung (20) zu übertragen, die von der elektrischen Schaltvorrichtung (15) entfernt ist,
wobei das Hilfsmodul (57) **dadurch gekennzeichnet ist, dass** es ein zweites Gehäuse (75), eine erste Leiterplatte (100), eine zweite Leiterplatte (105) und ein bewegliches Element (125) umfasst, wobei das zweite Gehäuse (75) eine Kammer begrenzt, die die erste Leiterplatte (100) und die zweite Leiterplatte (105) aufnimmt, die erste Leiterplatte (100) die Steuerung (80) trägt und sich in einer ersten Ebene erstreckt, wobei die zweite Leiterplatte (105) mit der ersten Leiterplatte (100) verbunden ist und sich von der ersten Leiterplatte (100) in einer Richtung senkrecht zu der ersten Ebene erstreckt, die zweite Leiterplatte (105) eine elektrische Schaltung trägt, die mit der Steuerung (80) verbunden ist, wobei das bewegliche Element (125) konfiguriert ist, um durch das Signalisierungselement (50) in einer Translationsrichtung (X) zwischen einer ersten Position, in der die elektrische Schaltung offen ist, und einer zweiten Position, in der das bewegliche Element (125) die elektrische Schaltung schließt, translatorisch bewegt zu werden, wobei der Zustand der Schaltvorrichtung (15) durch den offenen oder geschlossenen Zustand der elektrischen Schaltung angegeben wird.

2. Hilfsmodul nach Anspruch 1, wobei die Translationsrichtung (X) senkrecht zu einer zweiten Erstreckungsebene der zweiten Leiterplatte (105) ist, wobei die Translationsrichtung (X) insbesondere eine Richtung ist, gemäß der das Hilfsmodul (57) in den Steckplatz (65) eingesetzt oder aus dem Steckplatz (65) entfernt werden kann.

3. Hilfsmodul nach Anspruch 1 oder 2, wobei die zweite Leiterplatte (105) mindestens einen Vorsprung (210) aufweist, der in ein die erste Leiterplatte (100) durchsetzendes Loch eingesetzt ist, um eine relative Translation der zwei Leiterplatten (100, 105) zueinander in der ersten Ebene zu verhindern.

4. Hilfsmodul nach einem der Ansprüche 1 bis 3, wobei die erste Leiterplatte (100) mindestens zwei erste Verbindungskontakte (165) trägt und die zweite Leiterplatte (105) mindestens zwei zweite Verbindungsflächen (225) trägt, wobei jede erste oder zweite Fläche (165, 225) von einer Seite (175, 180, 215, 220) der entsprechenden Leiterplatte (100, 105) getragen wird, jede zweite Anschlussfläche (225) mit einer der ersten Anschlussflächen (165) verbunden ist, um einen elektrischen Strom zwischen der ersten Anschlussfläche (165) und der zweiten Anschlussfläche (225) fließen zu lassen, wobei die zwei zweiten Anschlussflächen (225) oder zwei der zweiten Anschlussflächen (225) mit dem genannten Stromkreis verbunden sind, wobei jede erste Anschlussfläche (165) durch eine Masse aus elektrisch leitendem Metall mit der entsprechenden zweiten Anschlussfläche (225) verlötet ist.

5. Hilfsmodul nach Anspruch 4, wobei die zweite Leiterplatte (105) zwei Seiten (215, 220) aufweist, die die zweite Leiterplatte (105) in einer Richtung (X) senkrecht zu der zweiten Ebene begrenzen, wobei jede der zwei Seiten (215, 220) der zweiten Leiterplatte (105) mindestens eine der zweiten Anschlussflächen (225) trägt.

6. Hilfsmodul nach Anspruch 5, wobei jede Leiterplatte (100, 105) für mindestens eine von der ersten oder der zweiten Fläche (165, 225) der betrachteten Leiterplatte (100, 105) eine Gruppe von Durchlässen aufweist, die die Leiterplatte (100, 105) in einer Richtung senkrecht zu der ersten oder der zweiten Ausdehnungsebene der jeweiligen Leiterplatte (100, 105) durchqueren, wobei jeder Durchlass durch die erste oder die zweite Fläche (165, 225) mündet und ein metallisches Element (195) enthält, das die jeweilige Leiterplatte (100, 105) durchquert.

7. Hilfsmodul nach einem der Ansprüche 1 bis 6, umfassend ein Element (95) zum Speichern elektrischer Energie, das bereitgestellt ist, um die Steuerung (80) und das Kommunikationsmodul (85) elektrisch zu versorgen, wobei sich das Speicherelement (95) in einer dritten Ebene parallel zu der ersten Ebene erstreckt und mindestens eine Seitenfläche (155) aufweist, die das Speicherelement (95) in der dritten Ebene begrenzt, wobei das Speicherelement (95) einen ersten elektrischen Kontakt und einen zweiten elektrischen Kontakt aufweist und konfiguriert ist, um eine elektrische Spannung zwischen dem ersten Kontakt und dem zweiten Kontakt aufzuerlegen, die Seitenfläche (155) den ersten elektrischen Kontakt trägt, wobei der erste elektrische Kontakt mit einem dritten elektrischen Kontakt (230) verbunden ist, der von der zweiten Leiterplatte (105) getragen wird, wobei der dritte elektrische Kontakt (230) über eine der zweiten Anschlussflächen (225) mit der Steuereinheit (80) und dem Kommunikationsmodul (85) verbunden ist, wobei die Anzahl der zweiten Anschlussflächen (225) drei oder mehr ist.

8. Hilfsmodul nach Anspruch 7, wobei die erste Leiterplatte (100) einen vierten elektrischen Kontakt (170) umfasst, der mit der Steuerung (80) und dem Kommunikationsmodul (85) verbunden ist, wobei der zweite elektrische Kontakt an dem vierten elektrischen Kontakt (170) anliegt.

9. Hilfsmodul nach einem der vorherigen Ansprüche, wobei das Kommunikationsmodul (85) eine Antenne (110) umfasst, wobei die Antenne (110) einen Bereich (120) ohne Metallbeschichtung der ersten Leiterplatte (100) und einen Erreger (115) umfasst, der konfiguriert ist, um mindestens eine elektromagnetische Welle in dem Bereich (120) zu erzeugen.

10. Hilfsmodul nach Anspruch 9, bereitgestellt für eine Schaltvorrichtung (15), deren erstes Gehäuse (25) eine Vorderseite (60) aufweist, die dazu bereitgestellt ist, für einen Bediener zugänglich zu sein, wenn die Schaltvorrichtung (15) in Betrieb ist, wobei, wenn das Hilfsmodul (57) in dem Steckplatz (65) aufgenommen ist, der Erreger (115) zwischen den Bereich (120) und die Vorderseite (60) eingefügt ist.

11. Hilfsmodul nach Anspruch 9 oder 10, bereitgestellt für eine Schaltvorrichtung (15), deren erstes Gehäuse (25) eine Vorderseite (60) aufweist, die bereitgestellt ist, für einen Bediener zugänglich zu sein, wenn die Schaltvorrichtung (15) in Betrieb ist, wobei die erste Leiterplatte (100) ein erstes Ende (185) und ein zweites Ende (190) aufweist, das erste Ende (185) und das zweite Ende (190) gemeinsam die erste Leiterplatte (100) in einer Richtung (X) senkrecht zu der Vorderseite (60) begrenzen, wobei das erste Ende (185) von dem ersten Ende (185) und dem zweiten Ende (190) das Ende (185, 190) ist, das der Vorderseite (60) am nächsten ist, wobei die Antenne (110) von dem ersten Ende (185) getragen wird.

12. Elektrische Schaltvorrichtung, umfassend mindestens einen Eingang (30), einen Ausgang (35), ein erstes Gehäuse (25), ein Hilfsmodul (57) nach einem der Ansprüche 1 bis 11 und ein Schaltmodul (40), das konfiguriert ist, um zwischen einer ersten Konfiguration, in der das Schaltmodul (40) den Fluss eines elektrischen Stroms zwischen dem Eingang (30) und dem Ausgang (35) zulässt, und einer zweiten Konfiguration, in der das Schaltmodul (40) den Fluss des Stroms zwischen dem Eingang (30) und dem Ausgang (35) verhindert, umzuschalten, wobei das erste Gehäuse (25) eine Kammer (55) begrenzt, die das Schaltmodul (40) aufnimmt, das erste Gehäuse (25) ferner einen Steckplatz (65) zum Aufnehmen des Hilfsmoduls (57) begrenzt, wobei der Steckplatz (65) mindestens ein Signalisierungselement (50) umfasst, das konfiguriert ist, um dem Hilfsmodul (57) erste Informationen in Bezug auf einen Zustand der elektrischen Schaltvorrichtung (15) zu übertragen, wenn das Hilfsmodul (57) in dem Steckplatz (65) aufgenommen ist.

13. Elektrische Schaltvorrichtung nach Anspruch 12, wobei das erste Gehäuse (25) eine Vielzahl von Aufnahmestellen (65) begrenzt, die jeweils konfiguriert sind, um ein Hilfsmodul (57) nach einem der Ansprüche 1 bis 12 aufnehmen, wobei jede Aufnahmestelle (65) mit einem jeweiligen Zustand der elektrischen Schaltvorrichtung (15) assoziiert ist, der sich von dem Zustand unterscheidet, der mit jedem anderen Aufnahmestelle (65) assoziiert ist, wobei jede Aufnahmestelle (65) ein jeweiliges Signalelement (50) umfasst, das konfiguriert ist, um einem Hilfsmodul (57) erste Informationen in Bezug auf den assoziierten Zustands zu übertragen, wenn das Hilfsmodul (57) in der Aufnahmestelle (65) aufgenommen ist.

14. System zur Überwachung einer elektrischen Anlage, umfassend mindestens eine Schaltvorrichtung (15) nach Anspruch 12 oder 13 und eine Überwachungsvorrichtung (20), die konfiguriert ist, um jede von dem oder den Hilfsmodul(en) (57) übertragene Nachricht zu empfangen.

## Claims

1. An auxiliary module (57) for an electrical switching device (15), the electrical switching device (15) comprising at least one input (30), an output (35), a first housing (25) and a switching module (40) configured to switch between a first configuration in which the switching module (40) allows electrical current to flow between the input (30) and the output (35) and a second configuration in which the switching module (40) prevents current from flowing between the input (30) and the output (35), the first housing (25) delimiting a chamber (55) accommodating the switching module (40), the first housing (25) further delimiting a slot (65) for receiving the auxiliary module (57), the slot (65) comprising at least one signalling member (50) configured for transmitting to the auxiliary module (57) a first item of information relating to a state of the electrical switching device (15) when the auxiliary module (57) is received in the slot (65),
the auxiliary module (57) comprising a controller (80) configured to generate a message containing second information representative of the first transmitted information, and a radio frequency communication module (85) configured to transmit the message, via a radio frequency data link, to a device (20) remote from the electrical switching device (15),
the auxiliary module (57) being **characterised in that** it comprises a second housing (75), a first printed circuit board (100), a second printed circuit board (105), and a movable element (125), the second housing (75) delimiting a chamber accommodating the first board (100) and the second board (105), the first printed circuit board (100) carrying the controller (80) and extending in a first plane, the second printed circuit board (105) being connected to the first printed circuit board (100) and extending from the first printed circuit board (100) in a direction perpendicular to the first plane, the second printed circuit board (105) carrying an electrical circuit connected to the controller (80), the mobile element (125) being configured so that it can be moved in translation by the signalling member (50) in a direction of translation (X) between a first position in which the electrical circuit is open and a second position in which the mobile element (125) closes the electrical circuit, the state of the switching device (15) being indicated by the open or closed state of said electrical circuit.

2. The auxiliary module according to claim 1, in which the direction of translation (X) is perpendicular to a second plane of extension of the second printed circuit board (105), the direction of translation (X) being in particular a direction in which the auxiliary module (57) is suitable for being inserted into the slot (65) or extracted from the slot (65).

3. The auxiliary module according to claim 1 or 2, in which the second printed circuit board (105) comprises at least one protrusion (210) inserted into a hole passing through the first printed circuit board (100) so as to prevent relative translation of the two printed circuit boards (100, 105) with respect to each other in the first plane.

4. The auxiliary module according to any one of claims 1 to 3, in which the first printed circuit board (100) carries at least two first connection pads (165) and the second printed circuit board (105) carries at least two second connection pads (225), each first or second pad (165, 225) being carried by a face (175, 180, 215, 220) of the corresponding board (100, 105), each second pad (225) being connected to one of the first connection pads (165) to allow an electric current to flow between the first connection pad (165) and the second connection pad (225), the two second pads (225) or two of the second connection pads (225) being connected to said electrical circuit, each first pad (165) being soldered to the corresponding second pad (225) by a mass of electrically conductive metal.

5. The auxiliary module according to claim 4, in which the second printed circuit board (105) has two faces (215, 220) delimiting the second board (105) in a direction (X) perpendicular to the second plane, each of the two faces (215, 220) of the second board (105) carrying at least one of the second connection pads (225).

6. The auxiliary module according to claim 5, in which each printed circuit board (100, 105) comprises, for at least one of the first or second pads (165, 225) of the board (100, 105) in question, a set of vias passing through the board (100, 105) in a direction perpendicular to the first or second plane of extension of the board (100, 105) in question, each via emerging through the first or second pad (165, 225) and containing a metal element (195) passing through the printed circuit board (100, 105) in question.

7. The auxiliary module according to any one of claims 1 to 6, comprising an electrical energy storage member (95) designed to supply electrical energy to the controller (80) and the communication module (85), the storage member (95) extending in a third plane parallel to the first plane and having at least one lateral face (155) delimiting the storage member (95) in the third plane, the storage member (95) comprising a first electrical contact and a second electrical contact and being configured to impose an electrical voltage between the first contact and the second contact, the lateral face (155) carrying the first electrical contact, the first electrical contact being connected to a third electrical contact (230) carried by the second printed circuit board (105), the third electrical contact (230) being connected to the controller (80) and to the communication module (85) via one of the second connection pads (225), the second connection pads (225) being three or more in number.

8. The auxiliary module according to claim 7, in which the first printed circuit board (100) comprises a fourth electrical contact (170) connected to the controller (80) and to the communication module (85), the second electrical contact bearing against the fourth electrical contact (170).

9. The auxiliary module according to any one of the preceding claims, in which the communication module (85) comprises an antenna (110), the antenna (110) comprising an area (120) free of metal coating of the first printed circuit board (100) and an exciter (115) configured to generate at least one electromagnetic wave in said zone (120).

10. The auxiliary module according to claim 9, provided for a switching device (15) whose first housing (25) has a front face (60) intended to be accessible by an operator when the switching device (15) is in operation, in which, when the auxiliary module (57) is accommodated in said slot (65), the exciter (115) is interposed between the said zone (120) and said front face (60).

11. The auxiliary module according to claim 9 or 10, provided for a switching device (15) whose first housing (25) has a front face (60) intended to be accessible by an operator when the switching device (15) is in operation, in which the first printed circuit board (100) has a first end (185) and a second end (190), the first end (185) and the second end (190) together delimiting the first board (100) in a direction (X) perpendicular to the front face (60), the first end (185) being, among the first end (185) and the second end (190), the end (185, 190) closest to the front face (60), in which the antenna (110) is carried by the first end (185).

12. An electrical switching device comprising at least one input (30), an output (35), a first housing (25), an auxiliary module (57) according to any one of the claims 1 to 11 and a switching module (40) configured to switch between a first configuration in which the switching module (40) allows electrical current to flow between the input (30) and the output (35) and a second configuration in which the switching module (40) prevents current from flowing between the input (30) and the output (35), the first housing (25) delimiting a chamber (55) accommodating the switching module (40), the first housing (25) further delimiting a slot (65) for receiving the auxiliary module (57), the slot (65) comprising at least one signalling member (50) configured for transmitting to the auxiliary module (57) a first item of information relating to a state of the electrical switching device (15) when the auxiliary module (57) is received in the slot (65).

13. The electrical switching device according to claim 12, in which the first housing (25) delimits a plurality of receiving slots (65) each configured to accommodate an auxiliary module (57) according to any one of claims 1 to 12, each receiving slot (65) being associated with a respective state of the electrical switching device (15), different from the state associated with each other receiving slot (65), each receiving slot (65) comprising a respective signalling member (50) configured to transmit to an auxiliary module (57) a first item of information relating to the associated state when the auxiliary module (57) is received in the receiving slot (65).

14. A system for monitoring an electrical installation, comprising at least one switching device (15) according to claim 12 or 13 and a monitoring device (20) configured to receive each message transmitted by the auxiliary module(s) (57).
